# FASCICULE DE BREVET EUROPEEN

(11) **EP 3 290 791 B1**
(45) Date de publication et mention de la délivrance du brevet: **26.06.2019**
(21) Numéro de dépôt: 17184851.8
(22) Date de dépôt: 04.08.2017
(51) Int. Cl.: F21V 29/70, F28F 3/02, H01L 23/367, F21V 29/74

(54) **MODULE LUMINEUX DE VEHICULE AUTOMOBILE A ORGANE DE REFROIDISSEMENT**
LEUCHTMODUL EINES KRAFTFAHRZEUGS MIT KÜHLORGAN
MOTOR VEHICLE LIGHT MODULE WITH COOLING MEMBER

(30) Priorité: 01.09.2016 FR 1658126
(43) Date de publication de la demande: 07.03.2018
(73) Titulaire: Valeo Vision, 93012 Bobigny Cedex (FR)
(72) Inventeur: ELHACHIR, Brahim, 93012 BOBIGNY Cedex (FR); DUARTE, Marc, 93012 BOBIGNY (FR); ANDRE, Stephane, 93012 BOBIGNY Cedex (FR); TEXIER, Christian, 93012 BOBIGNY Cedex (FR)
(74) Mandataire: Oggioni, Baptiste

(56) Documents cités:
- EP-A1- 2 636 981
- WO-A1-2016/030156
- GB-A- 2 495 977
- US-A1- 2014 153 248
- US-A1- 2015 377 473

## Description

L'invention relève du domaine des dispositifs d'éclairage et/ou de signalisation pour les véhicules automobiles, et elle concerne plus particulièrement les modules lumineux destinés à être montés dans un projecteur pour véhicule et les organes de refroidissement associés à ces modules.

Les projecteurs de véhicules automobiles sont habituellement composés d'un boîtier qui est fermé par une paroi transparente à travers laquelle émergent un ou plusieurs faisceaux lumineux. Ce boîtier forme de la sorte un logement pour au moins un module lumineux, comprenant principalement une source lumineuse et un système optique de mise en forme de la lumière générée par la source lumineuse pour l'émission du faisceau lumineux par le projecteur.

Ces dernières années, l'utilisation de sources lumineuses constituées d'au moins une diode électroluminescente, ou LED pour l'acronyme anglais de « Light emitting diode », s'est propagée en raison de leur faible consommation en énergie, de leur faible encombrement et de la qualité de l'éclairage obtenu. Cependant, l'utilisation de diodes électroluminescentes présente comme inconvénient de produire de la chaleur, alors que la chaleur s'avère être nuisible pour le bon fonctionnement des diodes électroluminescentes. En effet, plus une diode électroluminescente monte en température, plus le flux lumineux qu'elle est susceptible d'émettre diminue.

On comprend que cet inconvénient est d'autant plus fort lorsque le module lumineux est conçu pour générer un faisceau nécessitant une forte intensité lumineuse, tel que pour des feux de croisement, des feux de route ou des feux anti-brouillard, le nombre de diodes électroluminescentes et/ou la puissance nécessaire à leur fonctionnement étant alors élevé. Du fait de la forte montée en température du module lumineux durant son utilisation, il est nécessaire de réduire la température dans le module lumineux pour éviter toute disfonctionnement de la ou des sources lumineuses, inhérent à une chaleur excessive.

Pour assurer un refroidissement efficace des diodes électroluminescentes, on sait utiliser un organe de refroidissement, qui comporte d'une part une partie de fixation à une base elle-même porteuse des diodes électroluminescentes et d'autre part une partie dissipatrice de chaleur formée notamment d'ailettes montés en série élastiquement les unes par rapport aux autres et porteuse de la partie de fixation, l'écartement des ailettes jouant sur la dimension de la partie de fixation. La partie de fixation a également pour fonction de transférer par conduction des calories depuis la base vers la partie dissipatrice de l'organe de refroidissement.

La partie de fixation est sensiblement plane pour être plaquée contre une face de la base et elle comporte des portions de connexion formant la surface d'appui sur la base, ainsi que des moyens d'indexage, par exemple des orifices, disposés aux extrémités latérales de cette partie de fixation configurées pour coopérer avec des moyens d'indexages complémentaires, par exemple des pions, portés par la base.

Les portions de connexion permettent la fixation de l'organe de refroidissement à l'aide de colle enserrée entre la base porteuse des diodes électroluminescentes et les portions de connexion, et cette colle permet l'immobilisation de l'organe de refroidissement dans la position définie par la coopération des moyens d'indexage.

En pratique, afin de prendre en considération les jeux de fabrication qui peuvent provoquer un désalignement des moyens d'indexage, il est prévu un écartement des moyens d'indexage de l'organe de refroidissement plus grand que l'écartement des pions portés par la base, étant entendu qu'il est plus facile de comprimer la tôle pliée formant l'organe de refroidissement pour faire correspondre les moyens d'indexage portés par la tôle avec les pions portés par la base que d'avoir à écarter l'une de l'autre les ailettes de l'organe de refroidissement. Ainsi lors du montage, on exerce une contrainte sur la partie dissipatrice pour rapprocher latéralement les unes des autres les ailettes, de manière à rapprocher les moyens d'indexage agencés aux extrémités latérales de l'organe de refroidissement. Cette contrainte peut entrainer un chevauchement des portions de connexion l'une sur l'autre, et il peut en résulter une déformation plastique de l'une des portions de connexion.

On comprend que la déformation plastique d'une portion de connexion par suite d'un chevauchement sur ou sous une autre portion de connexion implique un défaut de planéité de l'ensemble de la partie de fixation, et donc espace variable entre la base et chacune des portions de connexion à combler de colle. Soit la quantité de colle est alors insuffisante pour combler cet espace plus important que celui prévu théoriquement et la fixation de l'organe de refroidissement est alors pénalisée, soit de la colle est disposée en plus pour combler le trou et la couche de colle utilisée pour fixer l'organe de refroidissement n'est alors pas homogène. Ce surplus de colle et la couche non régulière qui en résulte implique une diminution du rendement d'échange thermique entre la base et la partie dissipatrice, du fait des propriétés thermiques de dissipation de la colle insuffisantes, et/ou un échange thermique non homogène. WO 2016/030.156 divulgue un module lumineux selon le préambule de la revendication 1.

La présente invention a pour objectif de résoudre les inconvénients décrits ci-dessus en concevant un module lumineux présentant notamment un organe de refroidissement permettant le refroidissement de ce module de manière plus efficace.

Dans ce contexte, la présente invention concerne un module lumineux comportant une base, sur laquelle sont montés au moins une source lumineuse et un organe de refroidissement comprenant au moins deux ailettes, reliées entre elles de façon élastique et comportant chacune au moins une paroi de dissipation et une portion de connexion connectée thermiquement à la base par une interface thermique, et notamment de la colle. Selon l'invention, le module comprend au moins une cale apte à venir au contact d'une partie d'une ailette lors du rapprochement élastique de cette ailette avec une autre ailette.

On comprend par « apte à venir en contact » que dans une position de repos du module lumineux, c'est à dire sans que soit exercée sur ce module une contrainte par un opérateur, la cale n'est pas au contact de l'ailette mais en regard de celle-ci, et que c'est cette contrainte, provoquant le rapprochement élastique des ailettes qui met en contact la cale et l'ailette, et qui forme ainsi une butée empêchant le chevauchement des portions de connexion portées respectivement par les ailettes.

Selon une première série de caractéristiques, prises seules ou en combinaison, et propres à la formation de l'organe de refroidissement, on pourra prévoir que :
- l'organe de refroidissement est formé d'une unique tôle pliée ;
- l'organe de refroidissement est réalisé en matériau plastique, notamment moulé ;
- les au moins deux ailettes sont reliées entre elles de façon élastique par une première pliure ;
- la première pliure reliant une ailette à une autre ailette prolonge une extrémité d'une paroi de dissipation de chacune de ces ailettes ;
- la première pliure reliant deux ailettes entre elles s'étend à une extrémité distale de l'organe de refroidissement, c'est-à-dire une extrémité opposée aux portions de connexion et à la base lorsque l'organe de refroidissement est monté sur la base ;
- les ailettes comprennent deux parois de dissipation ;
- les parois de dissipation d'une même ailette sont reliées entre elles par une deuxième pliure, les première et deuxième pliures étant agencées à des extrémités opposées de l'organe de refroidissement ;
- la deuxième pliure entre deux parois de dissipation s'étend au droit d'au moins une portion de connexion portée par l'une des ailettes ;
- les parois de dissipation sont parallèles entre elles ;
- chaque portion de connexion d'une ailette prolonge une paroi de dissipation de cette ailette par l'intermédiaire d'un pli ;
- la paroi de dissipation et la portion de connexion sont sensiblement orthogonales ;
- les portions de connexion sont agencées sensiblement dans le même plan ;
- la deuxième pliure joignant deux ailettes est orthogonale au ou aux pli(s) reliant paroi de dissipation et portion de connexion.

Selon une autre série de caractéristiques, prises seules ou en combinaison entre elles, et potentiellement combinées avec l'une et/ou l'autre des caractéristiques de la première série citée ci-dessus, on pourra prévoir que
- la cale est venue de matière avec l'organe de refroidissement ; on entend couvrir par cette formulation le fait que la cale est monobloc avec telle ou telle partie de l'organe de refroidissement, c'est-à-dire que la séparation de la cale et de l'organe de refroidissement ne peut être faite sans destruction de l'un et/ou de l'autre ; dès lors, la cale n'est pas une pièce rapportée, distincte de l'organe de refroidissement et devant être fixée par ailleurs ;
- la cale est une pièce distincte de l'organe de refroidissement, par exemple réalisée en un matériau élastique, notamment en une mousse plastique ;
- la cale est agencée entre deux parois de dissipation d'une même ailette, apte à venir au contact avec au moins l'une des deux parois lors du rapprochement élastique de cette ailette avec une autre ailette ;
- la cale est venue de matière avec une paroi de dissipation d'une des ailettes et s'étendant vers l'autre ailette ; on comprend que dans ce cas, la cale s'étend en saillie orthogonale du plan défini par la paroi de dissipation ;
- la cale est venue de matière avec la portion de connexion de l'une des ailettes ;
- la cale présente la forme d'un doigt prolongeant la portion de connexion pour s'étendre entre deux ailettes ou entre deux parois de dissipation d'une même ailette : par doigt, on entend une protubérance en saillie de la portion de connexion qui présente des dimensions inférieures à celles de la portion de connexion, notamment selon la direction transversale définissant la direction de la série des ailettes et des portions de connexion ;
- la cale prolonge la portion de connexion depuis un bord latéral de celle-ci, sensiblement parallèle à la paroi de dissipation le long duquel s'étend la cale ;
- la cale s'étend selon une direction orthogonale au plan défini par la portion de connexion de l'ailette associée, notamment par un pli avec cette portion de connexion, ou bien elle s'étend dans le plan défini par la portion de connexion de l'ailette associée ;
- la cale est formée par un coin replié de la portion de connexion.

L'invention concerne également un projecteur de véhicule automobile comportant un module lumineux tel qu'il vient d'être décrit, et notamment un projecteur comportant un boîtier et une glace de fermeture définissant un logement de réception d'au moins un module lumineux.

D'autres caractéristiques et avantages de la présente invention apparaitront plus clairement à l'aide de la description et des dessins parmi lesquels :
- la figure 1 est une vue schématique en coupe d'un module lumineux selon un mode de réalisation de l'invention, dans lequel on a illustré une base support d'une source lumineuse et de deux organes de refroidissement, ainsi qu'un réflecteur des rayons émis par la source vers une lentille ;
- la figure 2 est une représentation en perspective d'une partie d'un module lumineux selon l'invention, comportant une base, trois sources lumineuses et un organe de refroidissement ;
- la figure 3 est une vue en perspective d'un organe de refroidissement selon un premier mode de réalisation de l'invention ;
- la figure 4 est une vue de détail de l'organe de refroidissement de la figure 3, pour rendre notamment visible une cale agencée entre deux parois de dissipation de l'organe de refroidissement ;
- la figure 5 est une représentation de la tôle dépliée servant à l'obtention de l'organe de refroidissement de la figure 3 ;
- les figures 6 et 7 sont des étapes du procédé d'obtention par pliage de l'organe de refroidissement de la figure 3 ; et
- la figure 8 est une vue de détail d'un organe de refroidissement selon un deuxième mode de réalisation de l'invention.

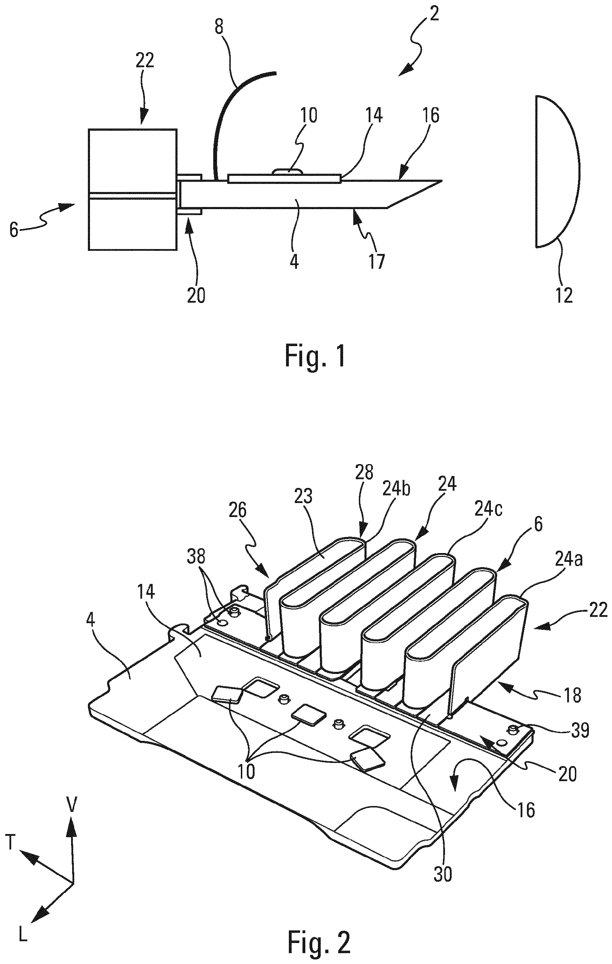

Dans la description qui va suivre, on adoptera à titre non limitatif une orientation longitudinale, verticale et transversale selon l'orientation traditionnellement utilisée dans l'automobile et illustrée par le trièdre L,V,T de la figure 2. De plus, les termes inférieur et supérieur doivent être interprétés à la lumière de la position du module lumineux dans le véhicule automobile lorsque ce module est en position normale d'utilisation.

La figure 1 représente un module lumineux 2 destiné à être fixé dans un boitier (non représenté) d'un projecteur d'un véhicule automobile.

Le module comporte une base 4 sur laquelle sont rapportés au moins un organe de refroidissement 6, un réflecteur de lumière 8, et une ou plusieurs sources de lumière 10, consistant ici en des diodes électroluminescentes 10. La source de lumière 10 est disposée en regard du réflecteur de lumière 8 de sorte que les rayons lumineux émis par la source sont dirigés vers ce dernier pour qu'il les dévie vers un élément optique 12, prenant ici la forme d'une lentille.

On comprend que, sans sortir du contexte de l'invention, on pourra proposer un module lumineux avec un système optique de mise en forme différent de celui, présenté ici, formé par le réflecteur et la lentille.

La source de lumière 10 peut être montée sur une plaque de circuit imprimée 14, l'ensemble étant supporté par la base 4. L'organe de refroidissement 6, dont la fonction est de dissiper la chaleur produite par la source de lumière 10, est également disposé sur cette base 4, sensiblement au voisinage de la source de lumière 10. Sur la figure 1, on a illustré deux organes de refroidissement disposés en regard de l'une de l'autre, de part et d'autre du plan défini par la base 4. Dans ce qui suit, seul un organe de refroidissement sera illustré et décrit mais, de façon symétrique, deux organes de refroidissement pourront être fixés sur la base.

On comprend que la base 4 a une fonction de support mécanique pour la source de lumière 10 et pour l'organe de refroidissement 6 également et qu'elle participe au transfert de la chaleur produite par la source de lumière en fonctionnement vers l'organe de refroidissement 6, dont la forme, décrite ci-après, permet l'évacuation de chaleur à distance de la source de lumière.

On a illustré sur la figure 2 un mode de réalisation dans lequel la base 4 supporte trois diodes électroluminescentes et l'organe de refroidissement 6.

La base 4 présente une forme de plaque sensiblement plane, avec une première face 16 et une deuxième face opposée 17. A une première extrémité longitudinale de la base, des moyens de fixation sont prévus pour immobiliser l'organe de refroidissement, tandis que l'extrémité longitudinale opposée de la base peut présenter une forme biseautée pour former un bord de coupure des rayons émis par la source et déviés par le réflecteur.

L'organe de refroidissement 6 est fixé à la première extrémité longitudinale de la base 4, de sorte qu'une première partie 18 de l'organe de refroidissement 6 soit sans contact avec la base 4. Cette configuration particulière permet d'augmenter la surface d'échange de l'organe de refroidissement 6 avec l'air environnant.

La première face 16 est configurée pour recevoir la ou les sources de lumière 10 et la carte de circuit imprimés. Dans l'exemple illustré sur la figure 2, c'est sur cette première face 16 que l'organe de refroidissement 6 est fixé au voisinage de la source de lumière 10, mais tel que cela a pu être précisé précédemment, on pourra prévoir qu'un deuxième organe de refroidissement soit fixé sur la deuxième face de façon symétrique au premier organe de refroidissement, ou bien on pourra prévoir qu'un seul organe de refroidissement est prévu, mais fixé sur la deuxième face.

L'organe de refroidissement 6 comprend une partie de fixation 20 et une partie dissipatrice de chaleur 22. Ces deux parties 20, 22 forment un ensemble monobloc, c'est-à-dire qu'elles sont réalisées en une pièce commune et qu'elles ne peuvent être séparées sans provoquer la rupture de l'une ou de l'autre.

L'organe de refroidissement est disposé par rapport à la base de sorte que la partie de fixation vient en recouvrement de la base, pour permettre la disposition d'une couche de colle, formant interface thermique, entre la partie de fixation et la base, et de sorte que la partie dissipatrice 22 est en partie sans contact avec la base 4.

L'organe de refroidissement est formé par pliage d'une pièce de tôle unique, le pliage formant notamment un ensemble à soufflet pour la partie dissipatrice de chaleur 22. Le matériau utilisé pour l'obtention de cette tôle peut notamment être de l'aluminium.

L'organe de refroidissement 6 comporte une pluralité de parois de dissipation 23, reliées deux à deux pour former une ailette 24. Ces parois de dissipation 23 sont sensiblement parallèles les unes aux autres. L'organe de refroidissement comprend au moins deux ailettes et dans le cas illustré, il comprend cinq ailettes respectivement formées par deux parois de dissipation.

Chaque paroi de dissipation et l'ailette qu'elle contribue à former présente une partie proximale 26, tournée vers la partie de fixation 20 et vers la base 4, et une partie distale 28 formant une extrémité libre à distance de la base. La partie proximale 26 de chaque paroi de dissipation porte une portion de connexion 30 qui prolonge sensiblement perpendiculairement la paroi de dissipation et qui sera décrite plus en détails ci-après, l'ensemble des portions de connexion formant la partie de fixation 20. On peut constater que la partie proximale présente une hauteur, c'est-à-dire une dimension selon la direction verticale, inférieure à la hauteur de la partie distale, de sorte qu'un épaulement 32 délimite ces parties distales et proximales de la paroi de dissipation. On pourra noter que l'épaulement 32 est destiné à buter contre l'épaisseur de la base 4 pour faciliter la mise en position et le maintien de l'organe de refroidissement 6 sur la base 4.

L'organe de refroidissement prend la forme d'une tôle pliée en plusieurs zones selon des axes de pliages A-A sensiblement verticaux, c'est-à-dire des axes sensiblement perpendiculaires à la direction principale d'allongement, longitudinale, des parois de dissipation, et sensiblement perpendiculaires au plan d'extension défini par la première face 16 de la base 4. Cette succession d'axes de pliage définit une série d'ailettes consécutives le long de la direction transversale.

Dans cette pluralité de zones de pliage, on peut notamment distinguer des premières pliures 33 reliant entre elles deux ailettes 24 successives au niveau de l'extrémité proximale 26 des parois de dissipation 23 les composant, et des deuxièmes pliures 34 reliant entre elles deux parois de dissipation d'une même ailette, au niveau de leur extrémité distale 28. L'alternance de première pliure et de deuxième pliure définit de la sorte une forme en serpentin depuis une première paroi de dissipation 23a disposée à une extrémité transversale de l'organe de refroidissement jusqu'à une deuxième paroi de dissipation 23b disposée à une extrémité transversale opposée de l'organe de refroidissement.

La pluralité d'ailettes juxtaposées en série transversale assure une grande surface d'échange avec l'air environnant permettant de dissiper rapidement les calories parvenues depuis la base 4 à l'organe de refroidissement 6.

Dans cette pluralité d'ailettes 24 formant la partie dissipatrice 22, on peut observer deux ailettes extérieures 24a,24b, disposées à chacune des extrémités transversales de l'organe de refroidissement et qui présentent ici une dimension longitudinale moindre de celle des autres ailettes qu'elles entourent, ainsi qu'une ailette centrale 24c.

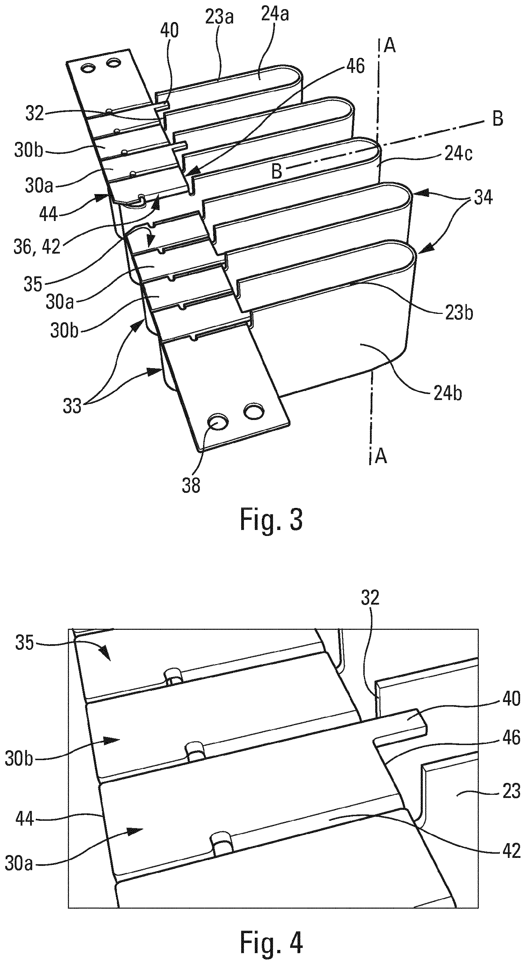

La partie dissipatrice 22 est rapportée sur la base 4 par l'intermédiaire de la partie de fixation 20, formée de plusieurs portions de connexion 30 distinctes entre elles. Ces portions de connexion 30 présentent chacune une première face de fixation 35 destinée à être rapportée contre la base 4, et l'agencement en une série transversale des portions de connexion, sensiblement dans le même plan, dispose les portions de connexion en une bande transversale de fixation. Les premières faces de fixations 35, visibles notamment sur la figure 3, sont fixées à la première face 16 de la base à l'aide d'un moyen d'adhésion, telle que de la colle présentant préférentiellement des propriétés de transfert thermique avantageuses.

Chaque paroi de dissipation 23 est prolongée par une portion de connexion 30, qui s'étend sensiblement perpendiculairement à cette paroi de dissipation en étant reliées ensemble par un pli 36. Les deux portions de connexion d'une même ailette sont pliées dans un même sens de sorte qu'une première portion de connexion 30a est pliée pour s'étendre sensiblement entre les deux parois de dissipation 23 d'une même ailette, entre l'extrémité proximale et l'épaulement 32 des parois de dissipation de cette ailette, et qu'une deuxième portion de connexion 30b est pliée pour s'étendre dans le même sens entre une paroi de dissipation d'une ailette et une paroi de dissipation d'une ailette voisine. Il peut être observé sur les figures que l'ailette centrale 24c diffère de cet agencement de sorte que ses portions de connexion sont pliées dans des sens opposés, chacune en éloignement de l'ailette qui les porte. De la sorte, l'ailette centrale définit un axe de symétrie longitudinal B-B de l'organe de refroidissement, un nombre égal de portions de connexion étant distribué de part et d'autre de cet axe de symétrie longitudinal.

Par ailleurs, les ailettes extérieures 24a, 24b diffèrent des autres ailettes en ce que la deuxième portion de connexion qu'elles portent, c'est-à-dire la portion de connexion pliée dans le sens de l'éloignement de l'ailette, porte des premiers moyens d'indexage 38. Ces premiers moyens d'indexage peuvent consister en des orifices configurés pour coopérer avec des deuxièmes moyens d'indexage portés par la base, et notamment des pions 39. Tel que cela a pu être précisé précédemment, l'alignement des pions 39 et des orifices des premiers moyens d'indexage 38 peut être obtenu par l'intermédiaire d'une contrainte exercée sur les ailettes de l'organe de refroidissement. La liaison élastique entre les ailettes, obtenue par la présence des zones de pliage, permet aux ailettes de se rapprocher les unes des autres, ou à tout le moins aux parois de dissipation d'une même ailette de se rapprocher les unes des autres.

Afin de s'assurer que le plan défini par l'agencement des premières faces de fixation des portions de connexion soit parfaitement plan, et d'assurer ainsi une zone de contact entre l'organe de refroidissement et la base qui soit d'épaisseur constante pour assurer notamment une homogénéité d'échange thermique, on prévoit selon l'invention de disposer une cale 40 en regard d'une partie d'une ailette, pour éviter le chevauchement des portions de connexion les unes sur les autres.

Dans ce qui va suivre, on va décrire un premier mode de réalisation, en se référant notamment aux figures 3 à 7, dans lequel la cale 40 est formée en saillie d'une portion de connexion 30. On prévoit ainsi d'équiper les portions de connexion, ou à tout le moins au moins une, d'une cale configurée pour venir au contact d'une paroi de dissipation 23.

Chaque portion de connexion présente la forme d'un élément rectangulaire avec un bord latéral 42 commun avec la paroi de dissipation, qui correspond au moins en partie avec le pli 36, et deux bords perpendiculaires à ce bord latéral parmi lesquels un bord d'extrémité longitudinale avant 44 tournée vers la source de lumière et un bord d'extrémité longitudinale arrière 46 tournée vers les ailettes.

La cale 40 prolonge la portion de connexion 30 depuis le bord d'extrémité longitudinale arrière 46 de sorte à s'étendre entre deux parois de dissipation. Dans le mode de réalisation illustré, à l'exception de l'ailette centrale 24c, chaque ailette 24 porte une cale 40, prolongeant en saillie la première portion de connexion 30a portée par l'ailette, c'est-à-dire la portion de connexion pliée de sorte à s'étendre entre les deux parois de dissipation 23 de l'ailette. On comprend dès lors que la cale 40 a pour effet de s'appuyer sur une paroi de dissipation 23 à l'intérieur de l'ailette 24 correspondante lorsque la pluralité d'ailette est déformée élastiquement. On pourrait prévoir d'équiper chaque portion de connexion d'une cale, mais dans le cas où une seule portion de connexion d'une ailette est équipée, on prévoira avantageusement que ce soit la première portion de connexion qui soit équipée de la cale, notamment pour permettre d'équiper d'une telle cale les ailettes extérieures, qui doivent par ailleurs porter les moyens d'indexage.

La cale 40 prolonge la portion de connexion et elle est venue de matière avec cette portion de connexion, dans le même plan défini par cette portion de connexion. Si on peut prévoir des variantes dans lesquelles la cale est pliée pour s'étendre sensiblement perpendiculairement au plan défini par la portion de connexion associée, il est ici avantageux d'avoir une disposition de la cale dans la continuité planaire de la portion de connexion, de sorte que l'on évite une zone de pliage pouvant fragiliser la cale lorsqu'elle entre en butée contre la paroi de dissipation.

La cale prend la forme d'un doigt s'étendant depuis le bord d'extrémité longitudinale arrière 46 de la portion de connexion, dans le prolongement du bord latéral libre, c'est-à-dire le bord latéral opposé au bord latéral commun 42 définissant le pli 36 entre la portion de connexion 30 et la paroi de dissipation 23. Il en résulte que la cale n'est pas centrée au milieu de l'ailette, entre les deux parois de dissipation, mais qu'elle s'étend au voisinage d'une des deux parois de dissipation, prête à entrer en contact avec celle-ci dès lors que les ailettes sont déformées élastiquement.

On comprend que cette cale 40 permet d'éviter que les portions de connexions 30 qui sont voisines ne se superposent ou se chevauchent entre elles. La cale 40 est destinée à venir au contact contre une paroi de dissipation 23 d'une ailette 24 pour limiter la course de la portion de connexion lors du rapprochement élastique de deux ailettes entre elles.

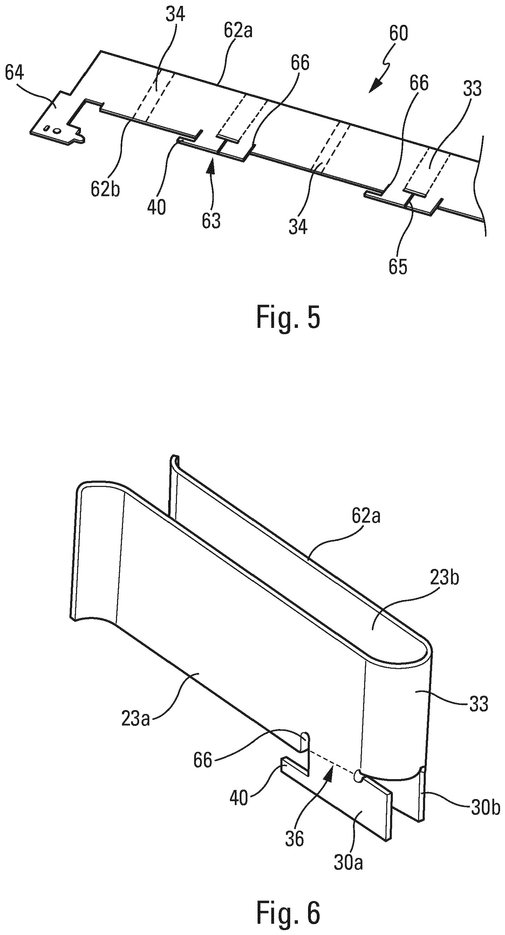

Tel que cela a pu être précisé, l'organe de refroidissement est formé d'une tôle pliée. On va maintenant décrire un procédé d'obtention par pliage de l'organe de refroidissement 6, en se référant notamment à la figure 5 sur laquelle on a représenté une partie de la tôle dépliée, des lignes de pliages étant représentées pour faciliter la compréhension des étapes de fabrication. On comprend que l'organe de refroidissement 6 est formée d'une seule pièce de tôle 60, à l'origine plane, de forme sensiblement longitudinale et délimitée par deux bords longitudinaux 62.

Un premier bord longitudinal 62a s'étend de façon rectiligne, tandis que le deuxième bord longitudinal opposé 62b comporte des découpes 63 configurées pour former, après pliages, les portions de connexion 30. A chaque extrémité transversale de la tôle dépliée, une découpe spécifique 64 est réalisée pour former la portion de connexion porteuse des premiers moyens d'indexage.

Les découpes 63 prennent la forme de deux portions en regard, sensiblement en forme de L, qui s'étendent en saillie du deuxième bord longitudinal 62b et séparées à leur extrémité libre par une fente 65 parallèle à l'axe des premières pliures 33. Des encoches 66 sont formées à la jonction du deuxième bord longitudinal et de la base de chacune des portions, pour faciliter par la suite le pliage des portions de connexion.

Les zones correspondant aux premières 33 et deuxièmes 34 pliures s'étendent d'un bord longitudinal 62 à l'autre.

On réalise la formation successive des ailettes les unes après les autres, en disposant un rouleau contre la tôle au niveau des différentes zones et en rabattant les parois de dissipation en regard les unes des autres. Après cette première étape de pliage, on a formé une série d'ailettes pour chacune desquelles les découpe 63 sont encore dans le même plan que les parois de dissipation 23.

Sur la figure 6, on a illustré deux parois de dissipation 23 parallèles l'une à l'autre, avec une première paroi de dissipation 23a faisant partie d'une première ailette et une deuxième paroi de dissipation 23b faisant partie d'une deuxième ailette directement voisine de la première ailette. Les deux ailettes sont jointes par une première pliure 33 au voisinage de laquelle s'étendent les portions de connexion. On a ici une première portion de connexion 30a prolongeant la première paroi de dissipation 23a et qui porte un doigt formant cale 40, et une deuxième portion de connexion 30b prolongeant la deuxième paroi de dissipation 23, sans cale. Tel que cela vient d'être précisé, les portions de connexion sont à ce stade dans le plan défini par la paroi de dissipation qu'elles prolongent respectivement.

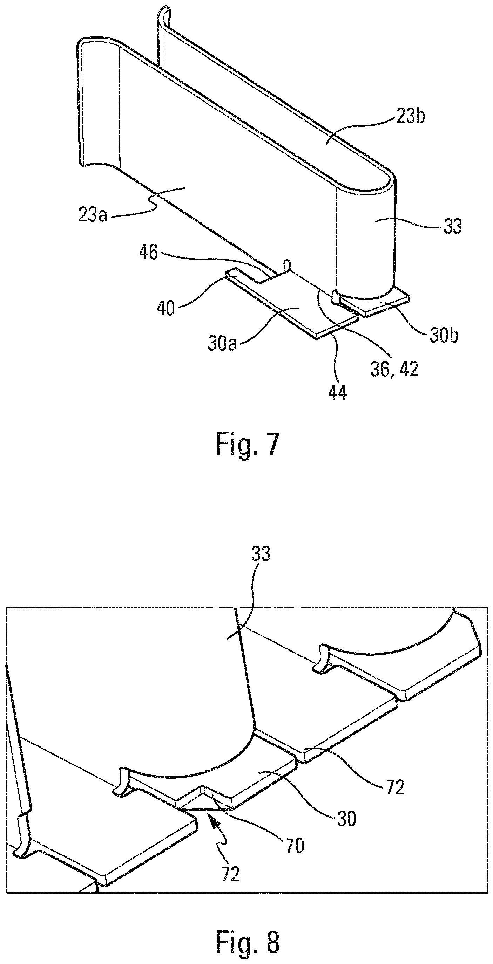

On plie alors les portions de connexion au niveau des plis 36 pour les rabattre et les disposer sensiblement orthogonalement à la paroi de dissipation qu'elles prolongent respectivement. Tel qu'illustré sur la figure 7, ces portions de connexion sont rabattues dans le même sens, de sorte que la première portion de connexion 30a porteuse de la cale s'étende entre deux parois de dissipation d'une même ailette et que la deuxième portion de connexion 30b, ici sans cale, s'étende entre une paroi de dissipation d'une ailette et une paroi de dissipation d'une deuxième ailette.

Le pliage des portions de connexion est facilité par la présence des encoches, qui définissent, lorsque l'organe de refroidissement est monté, les épaulements 32 entre la partie proximale 26 et la partie distale 28 des parois de dissipation 23.

Selon l'invention, les portions de connexions 30 sont configurées pour former une surface plane de fixation pour augmenter la surface de contact avec la base. De manière avantageuse, les portions de connexions 30 sont adjacentes mais ne se chevauchent pas du fait de la présence des cales 40 qui limitent le déplacement des ailettes 24 les unes par rapport aux autres lorsque l'on exerce une contrainte transversale sur celles-ci au moment de la mise en position de l'organe de refroidissement sur la base. On empêche ainsi une déformation plastique des portions de connexion 30, et on assure un espacement constant entre les faces de fixation des portions de connexion et la face de la base sur laquelle viennent être plaquées ces portions de connexion, et donc une épaisseur constante de colle. Ainsi le transfert thermique entre la base 4 et la partie dissipatrice 22 de l'organe de refroidissement 6 est amélioré grâce à une répartition homogène de la colle.

Des variantes de réalisation pourront être prévues sans que le contexte de l'invention soit changé, dès lors que des cales sont prévues en regard d'une partie de l'ailette, pour venir au contact de celle-ci lorsqu'au moins deux ailettes sont rapprochées élastiquement les unes des autres. A titre d'exemple non limitatif, on pourra prévoir que :
- les ailettes sont formées d'une seule paroi de dissipation et que seules des premières pliures soient prévues ;
- les cales s'étendent selon une direction perpendiculaire au plan défini par les portions de connexion ;
- au moins une cale est venue de matière avec une paroi de dissipation d'une des ailettes en s'étendant vers une ailette voisine ;
- les cales sont formées par une pièce rapportée fixées sur la portion de connexion ou sur la paroi de dissipation.

On a illustré sur la figure 8 une autre variante de réalisation, selon laquelle la cale est réalisée par une pliure 70 d'un coin 72 de la portion de connexion, et notamment un coin en regard d'une portion de connexion voisine. De la sorte, la cale ne s'étend pas dans le plan défini par les portions de connexion et forme une butée au chevauchement de ces portions de connexion voisine, la portion de connexion portant la cale ne pouvant se glisser sous la portion de connexion en regard de laquelle s'étend la cale. Conformément à l'invention, la cale est apte à venir en contact avec une partie de l'ailette, à savoir la portion de connexion.

## Revendications

1. Module lumineux (2) comportant une base (4), sur laquelle sont montés au moins une source lumineuse (10) et un organe de refroidissement (6) comprenant au moins deux ailettes (24), reliées entre elles de façon élastique et comportant chacune au moins une paroi de dissipation (23) et une portion de connexion (30) connectée thermiquement à la base par une interface thermique, **caractérisé en ce que** le module comprend au moins une cale (40) apte à venir au contact d'une partie d'une ailette lors du rapprochement élastique de cette ailette avec une autre ailette, la cale formant une butée empêchant le chevauchement des portions de connexion portées respectivement par les ailettes.

2. Module lumineux selon la revendication précédente, **caractérisé en ce que** l'organe de refroidissement (6) est formé d'une unique pièce de tôle (60) pliée.

3. Module lumineux selon l'une quelconque des revendications précédentes, **caractérisé en ce que** les au moins deux ailettes (24) sont reliées entre elles de façon élastique par une première pliure (33).

4. Module lumineux selon la revendication précédente, **caractérisé en ce que** la première pliure (33) reliant une ailette (24) à une autre ailette prolonge une extrémité d'une paroi de dissipation (23) de chacune de ces ailettes.

5. Module lumineux selon l'une quelconque des revendications précédentes, **caractérisé en ce que** les ailettes (24) comprennent deux parois de dissipation (23).

6. Module lumineux selon la revendication précédente, en combinaison avec au moins la revendication 3, **caractérisé en ce que** les parois de dissipation (23) d'une même ailette (24) sont reliées entre elles par une deuxième pliure (34), les première et deuxième pliures étant agencées à des extrémités opposées de l'organe de refroidissement (6).

7. Module lumineux selon l'une quelconque des revendications précédentes, **caractérisé en ce que** chaque portion de connexion (30) d'une ailette (24) prolonge une paroi de dissipation (23) de cette ailette par l'intermédiaire d'un pli (36).

8. Module lumineux selon l'une quelconque des revendications précédentes, **caractérisé en ce que** la cale (40) est venue de matière avec l'organe de refroidissement (6).

9. Module lumineux selon l'une des revendications précédentes, en combinaison avec au moins la revendication 5, **caractérisé en ce que** la cale (40) est agencée entre deux parois de dissipation (23) d'une même ailette (24), apte à venir au contact avec au moins l'une des deux parois lors du rapprochement élastique de cette ailette avec une autre ailette.

10. Module lumineux selon l'une quelconque des revendications 4 à 9, **caractérisé en ce que** la cale (40) est venue de matière avec une paroi de dissipation (23) d'une des ailettes (24) et s'étendant vers l'autre ailette.

11. Module lumineux selon l'une quelconque des revendications précédentes, **caractérisé en ce que** la cale (40) est venue de matière avec la portion de connexion (30) de l'une des ailettes.

12. Module lumineux selon l'une quelconque des revendications 1 à 11, **caractérisé en ce que** la cale (40) présente la forme d'un doigt prolongeant la portion de connexion (30) pour s'étendre entre deux ailettes (24) ou entre deux parois de dissipation (23) d'une même ailette.

13. Module lumineux selon la revendication précédente, **caractérisé en ce que** la cale (40) prolonge la portion de connexion (30) depuis un bord latéral (42) de celle-ci, sensiblement parallèle à la paroi de dissipation (23) le long duquel s'étend la cale.

14. Module lumineux selon l'une quelconque des revendications 12 ou 13, **caractérisé en ce que** la cale (40) s'étend dans le plan défini par la portion de connexion (30) de l'ailette (24) associée.

## Patentansprüche

1. Leuchtmodul (2), welches einen Sockel (4) aufweist, auf dem wenigstens eine Lichtquelle (10) und ein Kühlorgan (6), das wenigstens zwei Rippen (24) umfasst, die elastisch miteinander verbunden sind und jeweils wenigstens eine Wärmeableitungswand (23) und einen über eine thermische Schnittstelle mit dem Sockel thermisch verbundenen Verbindungsabschnitt (30) aufweisen, angebracht sind, **dadurch gekennzeichnet, dass** das Modul wenigstens ein Abstandsstück (40) umfasst, das dafür ausgelegt ist, mit einem Teil einer Rippe in Kontakt zu kommen, wenn eine elastische Annäherung dieser Rippe an eine andere Rippe erfolgt, wobei das Abstandsstück einen Anschlag bildet, der die Überlappung der von den Rippen jeweils getragenen Verbindungsabschnitte verhindert.

2. Leuchtmodul nach dem vorhergehenden Anspruch, **dadurch gekennzeichnet, dass** das Kühlorgan (6) aus einem einzigen gebogenen Blechteil (60) ausgebildet ist.

3. Leuchtmodul nach einem der vorhergehenden Ansprüche, **dadurch gekennzeichnet, dass** die wenigstens zwei Rippen (24) durch eine erste Biegung (33) elastisch miteinander verbunden sind.

4. Leuchtmodul nach dem vorhergehenden Anspruch, **dadurch gekennzeichnet, dass** die erste Biegung (33), die eine Rippe (24) mit einer anderen Rippe verbindet, ein Ende einer Wärmeableitungswand (23) jeder dieser Rippen verlängert.

5. Leuchtmodul nach einem der vorhergehenden Ansprüche, **dadurch gekennzeichnet, dass** die Rippen (24) zwei Wärmeableitungswände (23) umfassen.

6. Leuchtmodul nach dem vorhergehenden Anspruch in Verbindung wenigstens mit Anspruch 3, **dadurch gekennzeichnet, dass** die Wärmeableitungswände (23) ein und derselben Rippe (24) durch eine zweite Biegung (34) miteinander verbunden sind, wobei die erste und die zweite Biegung an entgegengesetzten Ende des Kühlorgans (6) angeordnet sind.

7. Leuchtmodul nach einem der vorhergehenden Ansprüche, **dadurch gekennzeichnet, dass** jeder Verbindungsabschnitt (30) einer Rippe (24) eine Wärmeableitungswand (23) dieser Rippe über einen Falz (36) verlängert.

8. Leuchtmodul nach einem der vorhergehenden Ansprüche, **dadurch gekennzeichnet, dass** das Abstandsstück (40) stoffschlüssig mit dem Kühlorgan (6) verbunden ist.

9. Leuchtmodul nach einem der vorhergehenden Ansprüche in Verbindung wenigstens mit Anspruch 5, **dadurch gekennzeichnet, dass** das Abstandsstück (40) zwischen zwei Wärmeableitungswänden (23) ein und derselben Rippe (24) angeordnet ist und dafür ausgelegt ist, bei der elastischen Annäherung dieser Rippe an eine andere Rippe mit wenigstens einer der zwei Wände in Kontakt zu kommen.

10. Leuchtmodul nach einem der Ansprüche 4 bis 9, **dadurch gekennzeichnet, dass** das Abstandsstück (40) stoffschlüssig mit einer Wärmeableitungswand (23) einer der Rippen (24) verbunden ist und sich in Richtung der anderen Rippe erstreckt.

11. Leuchtmodul nach einem der vorhergehenden Ansprüche, **dadurch gekennzeichnet, dass** das Abstandsstück (40) stoffschlüssig mit dem Verbindungsabschnitt (30) einer der Rippen verbunden ist.

12. Leuchtmodul nach einem der Ansprüche 1 bis 11, **dadurch gekennzeichnet, dass** das Abstandsstück (40) die Form eines Fingers aufweist, der den Verbindungsabschnitt (30) verlängert, um sich zwischen zwei Rippen (24) oder zwischen zwei Wärmeableitungswänden (23) ein und derselben Rippe zu erstrecken.

13. Leuchtmodul nach dem vorhergehenden Anspruch, **dadurch gekennzeichnet, dass** das Abstandsstück (40) den Verbindungsabschnitt (30) von einem seitlichen Rand (42) desselben aus verlängert, der im Wesentlichen parallel zu der Wärmeableitungswand (23) ist, an der entlang sich das Abstandsstück erstreckt.

14. Leuchtmodul nach einem der Ansprüche 12 oder 13, **dadurch gekennzeichnet, dass** sich das Abstandsstück (40) in der Ebene erstreckt, die durch den Verbindungsabschnitt (30) der zugeordneten Rippe (24) definiert ist.

## Claims

1. Lighting module (2) comprising a base (4), on which there are mounted at least one light source (10) and a cooling member (6) comprising at least two fins (24) joined together elastically and each comprising at least one heat-sink wall (23) and a connection portion (30) thermally connected to the base by a thermal interface, **characterized in that** the module comprises at least one stop piece (40) able to come into contact with part of a fin when this fin is brought elastically closer to another fin, the stop piece acting as a limit stop preventing overlapping of the connection portions respectively borne by the fins.

2. Lighting module according to the preceding claim, **characterized in that** the cooling member (6) is formed of a single piece (60) of bent sheet metal.

3. Lighting module according to either one of the preceding claims, **characterized in that** the at least two fins (24) are joined together elastically by a first bend (33).

4. Lighting module according to the preceding claim, **characterized in that** the first bend (33) joining one fin (24) to another fin prolongs an end of a heat-sink wall (23) of each of these fins.

5. Lighting module according to any one of the preceding claims, **characterized in that** the fins (24) comprise two heat-sink walls (23).

6. Lighting module according to the preceding claim in combination with at least Claim 3, **characterized in that** the heat-sink walls (23) of one and the same fin (24) are joined together by a second bend (34), the first and second bends being arranged at opposite ends of the cooling member (6).

7. Lighting module according to any one of the preceding claims, **characterized in that** each connection portion (30) of a fin (24) prolongs a heat-sink wall (23) of this fin by means of a bend (36).

8. Lighting module according to any one of the preceding claims, **characterized in that** the stop piece (40) is formed of a material with the cooling member (6) .

9. Lighting module according to one of the preceding claims in combination with at least Claim 5, **characterized in that** the stop piece (40) is arranged between two heat-sink walls (23) of the one same fin (24), and is able to come into contact with at least one of the two walls when this fin is brought elastically closer to another fin.

10. Lighting module according to any one of Claims 4 to 9, **characterized in that** the stop piece (40) is formed of a material with a heat-sink wall (23) of one of the fins (24) and extending toward the other fin.

11. Lighting module according to any one of the preceding claims, **characterized in that** the stop piece (40) is formed of a material with the connection portion (30) of one of the fins.

12. Lighting module according to any one of Claims 1 to 11, **characterized in that** the stop piece (40) has the form of a finger prolonging the connection portion (30) so as to extend between two fins (24) or between two heat-sink walls (23) of the one same fin.

13. Lighting module according to the preceding claim, **characterized in that** the stop piece (40) prolongs the connection portion (30) from a lateral edge (42) thereof, substantially parallel to the heat-sink wall (23) along which the stop piece extends.

14. Lighting module according to either one of Claims 12 and 13, **characterized in that** the stop piece (40) extends in the plane defined by the connection portion (30) of the associated fin (24).
